# EUROPÄISCHE PATENTSCHRIFT

(11) **EP 1 792 373 B1**
(45) Veröffentlichungstag und Bekanntmachung des Hinweises auf die Patenterteilung: **04.03.2009**
(21) Anmeldenummer: 05806660.6
(22) Anmeldetag: 20.09.2005
(51) Int. Cl.: H01S 5/026, H01S 5/183, H01S 5/04, H01S 5/02

(54) **SEITLICH OPTISCH GEPUMPTER OBERFLÄCHENEMITTIERENDER HALBLEITERLASER MIT EINER INTEGRIERTEN WÄRMESENKE**
LATERAL OPTICALLY PUMPED SURFACE-EMITTING SEMICONDUCTOR LASER WITH AN INTEGRATED HEAT SINK
LASER A SEMI-CONDUCTEURS A EMISSION PAR LA SURFACE A POMPAGE OPTIQUE LATERAL AVEC UN DISSIPATEUR THERMIQUE INTEGREE

(30) Priorität: 22.09.2004 DE 102004045949
(43) Veröffentlichungstag der Anmeldung: 06.06.2007
(73) Patentinhaber: OSRAM Opto Semiconductors GmbH, 93055 Regensburg (DE)
(72) Erfinder: ALBRECHT, Tony, 93077 Bad Abbach (DE); LUTGEN, Stephan, 93047 Regensburg (DE); REILL, Wolfgang, 93080 Pentling (DE); SCHWARZ, Thomas, 93055 Regensburg (DE); STEEGMÜLLER, Ulrich, 93055 Regensburg (DE)
(74) Vertreter: Epping - Hermann - Fischer
(86) Internationale Anmeldenummer: PCT/DE2005/001655
(87) Internationale Veröffentlichungsnummer: WO 2006/032252

(56) Entgegenhaltungen:
- WO-A-03/030316
- US-A- 5 422 901
- US-A1- 2002 176 459
- US-A1- 2004 141 538
- US-B1- 6 423 561
- SCHRAUD G ET AL: "Substrateless singlemode vertical cavity surface-emitting GaAs/GaAlAs laser diode" ELECTRONICS LETTERS, IEE STEVENAGE, GB, Bd. 30, Nr. 3, 3. Februar 1994 (1994-02-03), Seiten 238-239, XP006000167 ISSN: 0013-5194

## Beschreibung

Die Erfindung betrifft eine optisch gepumpte oberflächenemittierende Halbleiterlaservorrichtung und ein Verfahren zur Herstellung solch einer Halbleiterlaservorrichtung.

Die Druckschrift US 5,991,318 beschreibt einen optisch gepumpten Vertikalresonator-Halbleiterlaser mit einer monolithischen integrierten oberflächenemittierenden Halbleiterschichtstruktur. Bei dieser bekannten Vorrichtung wird die optische Pumpstrahlung, deren Wellenlänge kleiner ist als die der erzeugten Laserstrahlung, von einer kantenemittierenden Halbleiterdiode geliefert. Die kantenemittierende Halbleiterlaserdiode ist extern derart angeordnet, dass die Pumpstrahlung schräg von vorne in den Verstärkungsbereich der oberflächenemittierenden Halbleiterschichtstruktur eingestrahlt wird.
Die Druckschrift DE 100 267 34 A1 beschreibt eine optisch gepumpte oberflächenemittierende Halbleiterlaservorrichtung mit mindestens einer strahlungserzeugenden Quantentopfstruktur und mindestens einer Pumpstrahlquelle. Dabei dient die Pumpstrahlquelle zum optischen Pumpen der Quantentopfstruktur. Die Pumpstrahlquelle weist eine kantenemittierende Halbleiterstruktur auf. Die strahlungserzeugende Quantentopfstruktur und die kantenemittierende Halbleiterstruktur sind auf einem gemeinsamen Substrat epitaktisch aufgewachsen. Eine optisch gepumpte, oberflächenemittierende Halbleiterlaservorrichtung ist bekannt aus der Druckschrift US-A-2004/141538.

Es ist Aufgabe der vorliegenden Erfindung eine optisch gepumpte, oberflächenemittierende Halbleiterlaservorrichtung anzugeben, die besonders effizient gekühlt ist. Weiter ist es Aufgabe der Erfindung, Verfahren zur Herstellung solcher Halbleiterlaservorrichtungen anzugeben.

Diese Aufgabe wird gelöst durch eine Halbleiterlaservorrichtung nach Patentanspruch 1 sowie einem Verfahren zur Herstellung von Halbleiterlaservorrichtungen nach Patentanspruch 9. Vorteilhafte Ausgestaltungen sind Gegenstand der abhängigen Ansprüche.

Es wird eine oberflächenemittierende Halbleiterlaservorrichtung angegeben. Die Halbleiterlaservorrichtung enthält wenigstens einen oberflächenemittierenden Halbleiterlaser. Der oberflächenemittierende Halbleiterlaser enthält einen Vertikal-Emitter. Der Vertikal-Emitter umfasst wenigstens eine zur Erzeugung von elektromagnetischer Strahlung geeignete oberflächenemittierende Struktur. Besonders bevorzugt ist die oberflächenemittierende Struktur eine Quantentopfstruktur oder eine Mehrfachquantentopfstruktur.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Der Vertikal-Emitter enthält zudem bevorzugt einen Resonator, der wenigstens zwei-Resonatorspiegel umfasst. Besonders bevorzugt ist der Vertikal-Emitter zur Erzeugung von Laserstrahlung geeignet.

Der oberflächenemittierende Halbleiterlaser enthält ferner wenigstens eine Pumpstrahlquelle, die geeignet ist, den Vertikal-Emitter optisch zu pumpen. Besonders bevorzugt handelt es sich bei der Pumpstrahlquelle um eine kantenemittierende Halbleiterlaser-Struktur. Beispielsweise kann es sich bei der Pumpstrahlquelle um einen kantenemittierenden Breitstreifenlaser handeln.

Pumpstrahlquelle und Vertikal-Emitter sind auf einem gemeinsamen Substrat epitaktisch aufgewachsen. Das heißt, Pumpstrahlquelle und vertikal-Emitter sind nebeneinander auf einem gemeinsamen Substrat monolithisch integriert. Die Schichtdicken der einzelnen Halbleiterschichten lassen sich bei der Epitaxie sehr genau einstellen, sodass vorteilhafterweise eine hohe Positionierungsgenauigkeit der kantenemittierenden Struktur zur oberflächenemittierenden Struktur möglich ist. Bevorzugt ist die Pumpstrahlquelle dabei geeignet, den Vertikal-Emitter lateral zu pumpen. Das heißt, die Pumpstrahlung verläuft im Wesentlichen parallel zur Oberfläche des gemeinsamen Substrats, auf die der Halbleiterlaser abgeschieden ist und im Wesentlichen senkrecht zum vom Vertikal-Emitter erzeugten Laserstrahl.

Ferner enthält die oberflächenemittierende Halbleiterlaservorrichtung ein Wärmeleitelement. Das Wärmeleitelement befindet sich im thermischen Kontakt mit dem oberflächenemittierenden Halbleiterlaser. Das heißt, das Wärmeleitelement befindet sich bevorzugt sowohl mit der Pumpstrahlquelle bzw. den Pumpstrahlquellen und dem Vertikal-Emitter im thermischen Kontakt. Das Wärmeleitelement erlaubt dabei ein Abführen der beim Betrieb des oberflächenemittierenden Halbleiterlasers erzeugten Wärme. Bevorzugt wird die Wärme dabei im Wesentlichen mittels Wärmeleitung abgeführt. Im Wesentlichen mittels Wärmeleitung bedeutet dabei, dass andere Mechanismen des Wärmetransports höchstens eine untergeordnete Rolle spielen.

Das Wärmeleitelement weist zusätzlich eine Montagefläche auf. Die Montagefläche ist dabei zur Montage der Halbleiterlaservorrichtung auf einem Träger vorgesehen. Besonders bevorzugt wird die beim Betrieb des oberflächenemittierenden Halbleiterlasers entstehende Wärme vom Wärmeleitelement zur Montagefläche abgeführt und kann von dort an den Träger abgegeben werden. Bevorzugt wirkt der Träger dabei im Sinne einer Wärmesenke. Die Montagefläche kann sich beispielsweise auf einer dem Halbleiterlaser gegenüberliegenden Oberfläche des Wärmeleitelements befinden. Die Wärme wird vom oberflächenemittierenden Halbleiterlaser dann bevorzugt auf direktem Weg, d. h. ohne dass eine nennenswerte laterale Wärmeleitung stattfindet, zur Montagefläche weitergeleitet.

Das Substrat weist auf der dem Halbleiterlaser gegenüberliegenden Seite wenigstens eine Ausnehmung auf, die das Wärmeleitelement enthält. Durch diese Ausnehmung kann das Wärmeleitelement besonders nahe am Ort der größten Wärmeentwicklung angelagert sein. Die Ausnehmung ist dabei bevorzugt derart ausgebildet, dass eine elektrische Kontaktierung des Halbleiterlasers über das Wärmeleitelement möglich ist. Das heißt, das Substrat ist so weit entfernt, dass das Wärmeleitelement entweder direkt oder über beispielsweise eine dünne Substratschicht mit dem Halbleiterlaser kontaktierbar ist. In jedem Fall befinden sich Wärmeleitelement und Halbleiterlaser bevorzugt in elektrischem Kontakt zueinander.

In wenigsten einer Ausführungsform der oberflächenemittierenden Halbleiterlaservorrichtung ist das Wärmeleitelement elektrisch leitfähig. Das heißt, das Wärmeleitelement ist entweder aus einem elektrisch leitfähigen Material gebildet oder es enthält beispielsweise ein elektrisch isolierendes Material, auf zumindest Teilen dessen Oberfläche sich ein elektrisch leitendes Material befindet. Zum Beispiel kann das elektrisch isolierende Material dann mit einem elektrisch leitenden Material beschichtet sein.

Bevorzugt ist das Wärmeleitelement geeignet, den Halbleiterlaser elektrisch zu kontaktieren. Dazu ist vorteilhaft die elektrische Leitfähigkeit des Wärmeleitelements besonders hoch, sodass das Wärmeleitelement nur einen sehr geringen elektrischen Widerstand aufweist. Bevorzugt ist das Wärmeleitelement mit der Pumpstrahlquelle oder den Pumpstrahlquellen des oberflächenemittierenden Halbleiterlasers elektrisch kontaktiert, d. h. zwischen beispielsweise dem n-seitigen Kontakt der Pumpstrahlquelle und dem Wärmeleitelement besteht bevorzugt eine elektrisch leitende Verbindung. Die Pumpstrahlquelle kann aber auch p-seitig durch das Wärmeleitelement kontaktiert sein.

Besonders bevorzugt ist das Wärmeleitelement an seiner Montagefläche elektrisch leitend mit dem Träger verbunden.

Auf diese Weise ist der Halbleiterlaser bevorzugt über das Wärmeleitelement elektrisch mit dem Träger verbunden.

Das Wärmeleitelement enthält gemäß zumindest einer Ausführungsform bevorzugt eines der folgenden Materialien: Kupfer, Diamant, Silber, Al₂O₃, AlN, SiC, BN, Kupfer-Diamant. Enthält das Wärmeleitelement beispielsweise ein elektrisch isolierendes Material wie etwa BN, so sind auf das Material Leiterbahnen aus einem elektrisch leitenden Material aufgebracht, zum Beispiel aufgedruckt, die ein elektrisches Kontaktieren des Halbleiterlasers von der Montagefläche des Wärmeleitelements her ermöglichen.

In wenigsten einer Ausführungsform der oberflächenemittierenden Halbleiterlaservorrichtung besteht zwischen Wärmeleitelement und Halbleiterlaser eine thermisch beständige Verbindung. Das heißt, die Verbindung von oberflächenemittierendem Halbleiterlaser und Wärmeleitelement widersteht den beim Betrieb des oberflächenemittierenden Halbleiterlasers erzeugten Temperaturen, ohne ihre haftende Wirkung zu verlieren. Besonders bevorzugt ist die Verbindung dabei besonders gut thermisch leitfähig, sodass die erzeugte Wärme ohne nennenswerten Wärmestau im Bereich der Verbindung an das Wärmeleitelement abgegeben werden kann.

Weiter ist die Verbindung zumindest in den Teilbereichen des Halbleiterlasers, bei denen eine Verbindung zwischen der Pumpstrahlquelle und dem Wärmeleitelement besteht, elektrisch leitfähig.

Die Verbindung kann beispielsweise eine Lotverbindung sein. Das Lot kann dazu wenigstens eines der folgenden Materialien enthalten: Au, Sn, In, SnAg, AuSn, Ge, AuGe. Das heißt, es kommt sowohl Weich-, als auch Hartlöten in Frage. Es ist aber auch möglich, dass zwischen Wärmeleitelement und Halbleiterlaser eine galvanische Verbindung besteht. Das heißt, zwischen wärmeleitelement und Halbleiterlaser kann eine Verbindung bestehen, die durch einen galvanischen Abscheideprozess hergestellt ist.

Bevorzugt ist die Ausnehmung beispielsweise definiert in das Substrat geätzt. Es ist jedoch auch möglich, dass die Ausnehmung auf andere Weise, beispielsweise mechanisch, erzeugt wird.

In wenigstens einer Ausführungsform der oberflächenemittierenden Halbleiterlaservorrichtung ist das Wärmeleitelement galvanisch in die Ausnehmung des Substrats abgeschieden. Die Größe und Form des Wärmeleitelements ist dann im Wesentlichen durch Größe und Form der Ausnehmung vorgegeben. Bevorzugt füllt das Wärmeleitelement die Ausnehmung vollständig aus. Beispielsweise schließt das Wärmeleitelement im Wesentlichen bündig mit der dem oberflächenemittierenden Halbleiterlaser abgewandten Oberfläche des Substrats ab. Es ist aber auch möglich, dass eine dünne Schicht aus dem galvanisch abgeschiedenen Material zumindest Teile dieser Oberfläche bedeckt. Als Vorteil dieser Ausführungsform ergibt sich, dass die galvanischen Schichten bei Raumtemperatur in die Ausnehmung des Substrats abgeschieden werden können. Der Verzicht auf eine Verbindungstechnik wie etwa Löten verringert die thermische Belastung des Bauteils während des Herstellungsprozesses erheblich. Als mögliche Materialien kommen für das Wärmeleitelement dabei beispielsweise alle galvanisch abscheidbaren Metalle in Betracht. Besonders bevorzugt enthält das Wärmeleitelement Silber, Gold und/oder Kupfer.

In zumindest einer Ausführungsform der oberflächenemittierenden Halbleiterlaservorrichtung weist die Pumpstrahlquelle wenigstens eine geätzte Resonator-Facette auf. Bevorzugt sind die Laserfacetten der Pumpstrahlquellen beispielsweise mit einem Metall verspiegelt. Die Laserfacetten erstrecken sich bevorzugt senkrecht zur Pumpstrahlung, d.h. senkrecht zum Resonator des Kantenemitters, und sind bevorzugt durch ebene Flächen gebildet.

Es wird ferner ein Verfahren zur Herstellung einer oberflächenemittierenden Halbleiterlaservorrichtung angegeben.

Bei dem Verfahren zur Herstellung einer oberflächenemittierenden Halbleiterlaservorrichtung wird zunächst ein Substrat bereitgestellt, auf dem eine Vielzahl von oberflächenemittierenden Halbleiterlasern, die jeweils einen Vertikal-Emitter und wenigstens eine Pumpstrahlquelle aufweisen, monolithisch nebeneinander integriert sind.

Im nächsten Verfahrensschritt wird pro Halbleiterlaser auf der dem Halbleiterlaser gegenüberliegenden Seite des Substrats wenigstens eine Ausnehmung mittels eines Ätzprozesses erzeugt. Die Ausnehmung erstreckt sich dabei bevorzugt so tief in das Substrat und ist lateral so weit ausgedehnt, dass alle Pumpstrahlquellen eines Halbleiterlasers zum Kontaktieren zugänglich sind. Alternativ ist es möglich, dass pro Pumpstrahlquelle zusätzlich wenigstens eine Ausnehmung gebildet wird, über die die Pumpstrahlquelle zum elektrischen Kontaktieren zugänglich ist.

Im folgenden Verfahrensschritt wird ein Wärme leitendes Material galvanisch in die Ausnehmung des Substrats abgeschieden. Das Wärme leitende Material zeichnet sich bevorzugt durch eine sowohl thermisch als auch elektrisch sehr gute Leitfähigkeit aus, sodass mittels des Wärme leitenden Materials sowohl ein thermisches als auch ein elektrisches Anschließen des Halbleiterlasers möglich ist.

In einem abschließenden Verfahrensschritt wird die Anordnung aus Halbleiterlaser und Wärmeleitelementen zu oberflächenemittierenden Halbleiterlaservorrichtungen vereinzelt, die jeweils eine Halbleiterlaservorrichtung und wenigstens ein Wärmeleitelement aufweisen.

Im Folgenden wird die hier beschriebene oberflächenemittierende Halbleiterlaservorrichtung anhand von einem Ausführungsbeispiel und den dazugehörigen Figuren näher erläutert.
Figur 1 zeigt eine schematische Schnittdarstellung eines ersten Beispiels des hier beschriebenen oberflächenemittierenden Halbleiterlasers.
Figur 2 zeigt eine schematische Schnittdarstellung eines zweiten Beispiels des hier beschriebenen oberflächenemittierenden Halbleiterlasers.
Figur 3 zeigt eine schematische Schnittdarstellung eines ersten Beispiels zur Veranschaulichung der Erfindung der hier beschriebenen oberflächenemittierenden Halbleiterlaservorrichtung.
Figur 4 zeigt eine schematische Schnittdarstellung eines zweiten Beispiels zur Veranschaulichung der Erfindung der hier beschriebenen oberflächenemittierenden Halbleiterlaservorrichtung.
Figur 5 zeigt eine schematische Schnittdarstellung eines dritten Beispiels zur Veranschaulichung der Erfindung der hier beschriebenen oberflächenemittierenden Halbleiterlaservorrichtung.
Figur 6 zeigt eine schematische Schnittdarstellung eines Ausführungsbeispiels der hier beschriebenen oberflächenemittierenden Halbleiterlaservorrichtung.
Figur 7 zeigt eine schematische Schnittdarstellung eines Ausführungsbeispiels der hier beschriebenen oberflächenemittierenden Halbleiterlaservorrichtung auf einem Träger.
Figur 8 zeigt eine schematische Schnittdarstellung eines weiteren Ausführungsbeispiels der hier beschriebenen oberflächenemittierenden Halbleiterlaservorrichtung auf einem Träger.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

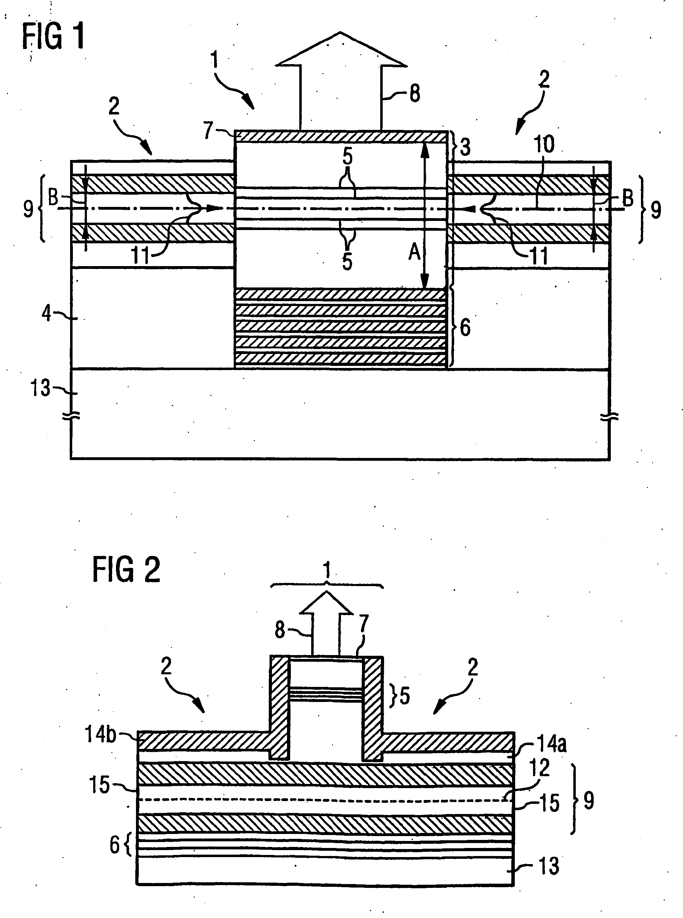

Der in Figur 1 dargestellte oberflächenemittierende Halbleiterlaser umfasst einen Vertikal-Emitter 1 und eine Pumpstrahlquelle 2.

Der Vertikal-Emitter 1 weist einen Zentralwellenleiter 3 sowie eine innerhalb des Zentralwellenleiters 3 angeordnete strahlungserzeugende Quantentopfstruktur mit einer Mehrzahl von Quantenschichten 5 auf. In vertikaler Richtung ist dem Zentralwellenleiter ein Spiegel 6 nachgeordnet. Vorzugsweise ist dieser Spiegel als Bragg-Spiegel mit einer Vielzahl alternierender Schichten mit unterschiedlichem Brechungsindex ausgeführt. Dem Spiegel gegenüberliegend ist auf der dem Substrat 13 abgewandten Seite auf den Zentralwellenleiter 3 eine Auskoppelschicht 7 aufgebracht, durch die die von dem Vertikal-Emitter erzeugte Strahlung 8 ausgekoppelt wird.

Der Spiegel 6 kann mit einem externen Spiegel (nicht dargestellt) einen externen Laserresonator für den Vertikal-Emitter bilden. Eine derartige Vorrichtung wird auch als VECSL (Vertical External Cacity Surface Emitting Laser) bezeichnet. Alternativ kann zur Ausbildung eines internen Resonators nach Art eines VCSEL (Vertical Cavity Surface Emitting Laser) zwischen Auskoppelschicht 7 und Zentralwellenleiter 3 ein teildurchlässiger Auskoppelspiegel, vorzugsweise ein Bragg-Spiegel, angeordnet sein.

Ferner kann in einem externen Laserresonator ein nicht-lineares optisches Element, beispielsweise ein nicht-linearer Kristall, zur Frequenzkonversion angeordnet sein. Diese Ausführung ist für eine Frequenzkonversion, insbesondere eine Frequenzvervielfachung wie etwa eine Frequenzverdoppelung der von der Quantentopfstruktur erzeugten Strahlung 8 vorteilhaft. Ebenso kann diese Ausführung des oberflächenemittierenden Halbleiterlasers für andere nichtlineare Konversionen wie beispielsweise Summenfrequenzerzeugung, Differenzfrequenzerzeugung, Erzeugung von Subharmonischen, Raman-Streuung oder Vierwellenmischen herangezogen werden, wobei optional das von dem Vertikal-Emitter generierte Strahlungsfeld mit einem weiteren, z. B. extern erzeugten Strahlungsfeld in dem nichtlinearen optischen Element überlagert wird.

Die lateral angeordneten beiden Pumpstrahlquellen 2 umfassen jeweils eine aktive Schicht sowie einen Pumpwellenleiter 9 mit einer Mittelachse 10, in den die Pumpstrahlung 11 geführt wird. Wie in Figur 1 angedeutet, weist die Pumpstrahlung 11 bevorzugt ein näherungsweise gaußförmiges Profil auf. Weiterhin kann eine Pufferschicht 4 vorgesehen sein, um die Pumpwellenleiter in vertikaler Richtung in geeigneter Höhe in Bezug auf den Zentralwellenleiter zu positionieren.

Die Quantenschichten 5 sind in einem vorgegebenen Abstand von der Mittelachse 10 angeordnet.

Vorzugsweise sind Pumplaser und Vertikal-Emitter monolithisch integriert, d. h. auf ein gemeinsames Substrat 13 epitaktisch aufgewachsen. Nach der Herstellung kann dieses Substrat 13 ausgedünnt oder auch vollständig entfernt werden. Alternativ ist der Spiegel 6 auf der Oberseite des Zentralwellenleiters 3 aufgebracht. Die Strahlungsauskopplung erfolgt dann auf der dem Spiegel gegenüberliegenden Seite durch das Substrat 13 hindurch. Bevorzugt ist im Bereich des Vertikal-Emitters 1 dann eine Grabenätzung im Substrat 13 vorhanden, die eine Auskopplung der Strahlung ermöglicht.

Es ist zudem möglich, dass mehr als zwei Pumpstrahlquellen 2, zum Beispiel vier oder sechs Pumpstrahlquellen 2 den Vertikalemitter 1 optisch pumpen. Die Pumpstrahlquellen 2 können dann kreuz- bzw. sternförmig um den Vertikalemitter 1 angeordnet sein.

Im Betrieb wird die von den Pumpstrahlquellen 2 erzeugte Pumpstrahlung lateral in die Quantentopfstruktur eingekoppelt und in den Quantenschichten 5 absorbiert und regt so die Emission der Strahlung 8 an (optisches Pumpen). Bei der Ausgestaltung des Vertikal-Emitters als Laser dient die Quantentopfstruktur als optisch gepumptes aktives Medium, in dem die Laserstrahlung durch stimulierte Emission generiert bzw. verstärkt wird.

Die Breite A des Zentralwellenleiters 3 ist bei diesem Ausführungsbeispiel größer als die Breite B des Pumpstrahlwellenleiters und ist derart an letztere angepasst, dass die Quantentopfstruktur des Vertikal-Emitters 1 gleichmäßig und vorzugsweise großflächig gepumpt wird. Im Einzelnen wird dies bei dem in Figur 1 gezeigten Ausführungsbeispiel durch eine Strahlaufweitung der Pumpstrahlung sowie eine beabstandete Anordnung der Quantenschichten 5 von der Mittelachse 10 der Pumpwellenleiter 9 erreicht.

Die Strahlaufweitung beruht auf der Beugung des Pumpstrahlungsfeldes 11 nach dem Übergang vom Pumpwellenleiter 9 in den deutlich breiteren Zentralwellenleiter 3. Die Anzahl der Moden im Zentralwellenleiter ist dabei so groß, dass näherungsweise eine freie Propagation der Pumpstrahlung im Zentralwellenleiter angenommen werden kann. Der Verlauf der Pumpstrahlung kann im Rahmen der Gaußschen Optik ermittelt werden.

Figur 2 zeigt eine schematische Schnittdarstellung eines zweiten Beispiels des hier beschriebenen oberflächenemittierenden Halbleiterlasers.

Es ist hier ein in Einschrittepitaxie gewachsener Scheibenlaser gezeigt, bei dem die Pumpstrahlung 11, von einer Mittelachse 12 des Pumpwellenleiters 9 aus gesehen, nach oben in die Quantentopfstruktur 5 des oberflächenemittierenden Lasers, die beispielsweise eine Vielzahl von Quantentöpfen enthält, eingekoppelt wird. Die Einkopplung in die Quantentopfstruktur 5 erfolgt dabei beispielsweise aufgrund von Sprüngen im Brechungsindex des Pumpwellenleiters 9. Die Pumpstrahlquellen 2 sind beispielsweise optisch gekoppelte Kantenemitter. Die Laserfacetten der Pumplaser 2 sind bevorzugt durch Ritzen und Brechen entlang der kristallographischen Achse des Substrats 13 und anschließendes Verspiegeln mit hoher Reflektivität (R > 90 %) hergestellt. Alternativ sind die Facetten durch Ätzen und anschließendes Verspiegeln gebildet.

Aufgrund der Verspiegelung mit hoher Reflektivität wird höchstens ein kleiner Anteil der Pumpstrahlung 11 aus dem lateralen Resonator ausgekoppelt. Über den resonatorinternen oberflächenemittierenden Laser 1 ist durch die Absorption der Pumpstrahlung in der Quantentopfstruktur 5 ein effizienter optischer Pumpmechanismus realisiert.

Der Vorteil dieses Ausführungsbeispiels liegt dabei in der fertigungstechnisch besonders einfachen Ausführungsform. Nach der Epitaxie ist im Bereich des Pumplasers 2 durch selektives Ätzen mittels Ätzstoppschicht definiert in den Wellenleiter geätzt und anschließend ein transparenter leitfähiger p-Kontakt 14a, der beispielsweise ein Zinkoxid enthalten kann, und eine p-Kontaktmetallisierung 14b aufgebracht, die vorzugsweise auch als metallischer Reflektor für das Pumplicht 11 dient.

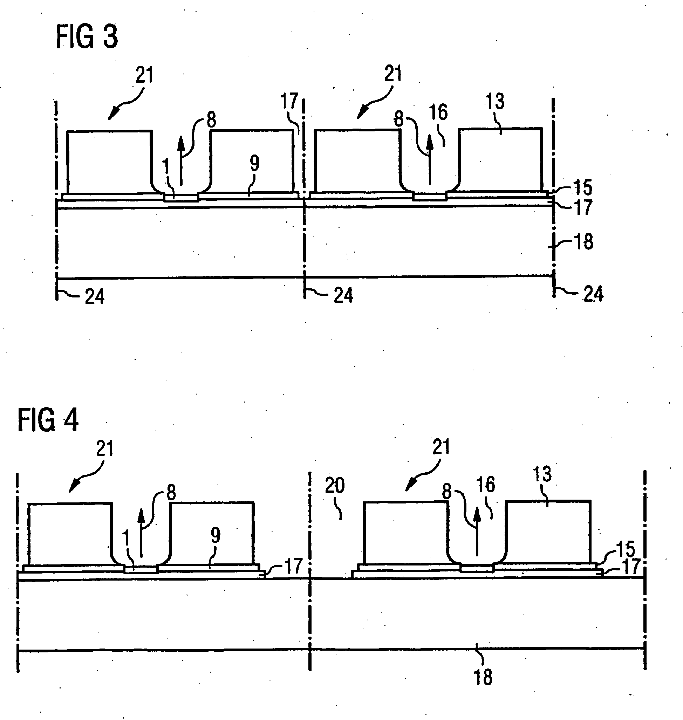

Figur 3 zeigt eine schematische Schnittdarstellung eines ersten Beispiels zur Veranschaulichung der Erfindung der hier beschriebenen oberflächenemittierenden Halbleiterlaservorrichtung.

Die Halbleiterlaser 21 - wie sie zum Beispiel in den Figuren 1 oder 2 beschrieben sind - sind hier als Scheibe auf eine Wärme leitende Scheibe 18 aufgebracht, die nach dem Vereinzeln der Anordnung das Wärmeleitelement bildet. Beispielsweise sind die beiden Scheiben mittels einer Lotschicht 17 mechanisch miteinander verbunden. Außerdem sind die Pumpstrahlquellen 9 der Halbleiterlaser über die Lotschicht 17 elektrisch mit der Wärme leitenden Scheibe 18 kontaktiert.

Die Wärme leitende Scheibe 18 ist dazu bevorzugt elektrisch leitfähig; sodass ein elektrisches Kontaktieren der Pumpstrahlquellen 9 über die Wärme leitende Scheibe 18 möglich ist. Die Wärme leitende Scheibe 18 enthält dabei beispielsweise ein elektrisch leitendes Material oder ist zumindest teilweise elektrisch leitend beschichtet. Mögliche Materialien für die Scheibe 18 und damit für das Wärmeleitelement sind Kupfer, Verbundwerkstoff Kupfer-Diamant, Diamant, Silber, Al₂O₃, AlN, SiC, BN oder Kombinationen dieser Materialien. Die Lotschicht 17 enthält bevorzugt wenigstens eins der folgenden Materialien oder Materialkombinationen: In, Sn, SnAg, Ag, Au, AuSn, AuGe.

Um den Vertikal-Emitter 1 für einen externen Resonator (nicht dargestellt) zugänglich zu machen, erfolgt eine Resonatorgrabenätzung 16, durch die die Strahlung 8 des Vertikal-Emitters 1 austreten kann.

Bei der Vereinzelung entlang der Linien 24 des Verbunds aus Halbleiterlaser und der Wärme leitenden Scheibe 18 werden Trennschnitte oder Trennätzungen 17 durch das Substrat 13 und die Pumpstrahlquellen 9 vorgenommen. Die Pumpstrahlquellen 9 sind für den Laserbetrieb bevorzugt an den Trennflächen 15 verspiegelt. Bevorzugt stehen die Trennflächen 15 dabei senkrecht zum Resonator der Pumpstrahlquelle 9 und sind eben ausgebildet. Die Trennflächen 15 bilden damit die Laserfacetten der Pumpstrahlquellen 9.

Erfolgen die Trennschnitte bzw. Trennätzungen zunächst nur in einer Richtung, so können die Halbleiterlaservorrichtungen jeweils parallel für ein Burn-In betrieben werden.

Es ist zudem möglich, dass die Resonatorgrabenätzung 19 und das Verspiegeln der Trennflächen 15 erst nach der Vereinzelung des Verbundes zu oberflächenemittierenden Halbleiterlaservorrichtungen mit jeweils einem Halbleiterlaser und einem Wärmeleitelement erfolgen.

Figur 4 zeigt eine schematische Schnittdarstellung eines zweiten Beispiels zur Veranschaulichung der Erfindung der hier beschriebenen Halbleiterlaservorrichtung.

Im Gegensatz zum vorherigen Ausführungsbeispiel werden die Halbleiterlaser 21 hier nicht im Scheibenverbund auf die Wärme leitende Scheibe 18 aufgebracht, sondern einzeln mittels beispielsweise eines Die-Bonding-Verfahrens mit einer Beabstandung 20 zwischen den einzelnen Halbleiterlasern 21. Vorteil dieser Methode ist, dass bereits hinsichtlich ihrer Funktionalität überprüfte Halbleiterlaser 21 auf die Wärme leitende Scheibe 18 aufgebracht werden und sich damit vorteilhaft der Ausschuss bei der Herstellung der Halbleiterlaservorrichtung reduzieren lässt. Zur Durchführung eines Burn-In können die Halbleiterlaser 21 auf der Scheibe 18 mit Drahtkontakten miteinander verbunden werden.

Die Grabenätzung 19 kann vor oder nach dem Verbinden erfolgen. Die Erzeugung der Pumplaserfacetten an den Trennflächen 15 kann vor und nach der Montage auf die Wärme leitende Scheibe 18 erfolgen. Ein gemeinsamer Burn-In der Halbleiterlaservorrichtungen kann mittels Verbinden der Halbleiterlaservorrichtungen durch Drahtkontakte untereinander durchgeführt werden.

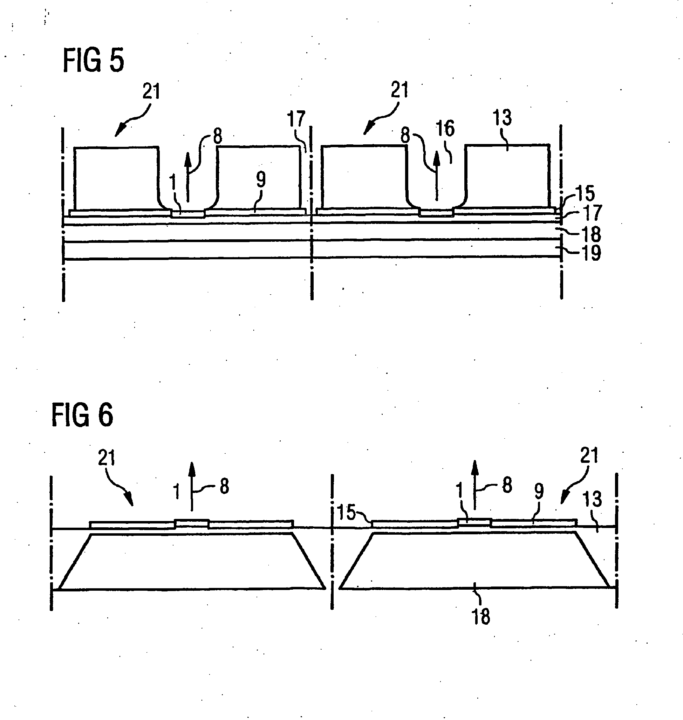

Figur 5 zeigt eine schematische Schnittdarstellung eines dritten Beispiels zur veranschaulichung der Erfindung der hier beschriebenen Halbleiterlaservorrichtung. Die Halbleiterlaser 21 sind hier auf eine Trennfolie 19 geklebt, die durch eine Metallschicht 18 verstärkt ist. Die Metallschicht 18 enthält beispielsweise Gold und ist zwischen 20 und 30 µm dick. Die Trennfolie 19 ist zum Beispiel durch eine Klebefolie gegeben.

Figur 6 zeigt eine schematische Schnittdarstellung durch ein viertes Ausführungsbeispiel der hier beschriebenen oberflächenemittierenden Halbleiterlaservorrichtung.

Hier werden in das Substrat 13 von der den oberflächenemittierenden Halbleiterlaser 21 abgewandten Seite her Ausnehmungen geätzt, in die galvanisch Schichten abgeschieden werden, die das Wärmeleitelement 18 bilden. Das Wärmeleitelement 18 enthält dabei bevorzugt Gold, Silber oder Kupfer. Der Vertikal-Emitter 1 und die Pumpstrahlquellen 9 befinden sich auf der Oberseite des Bauteils. Eine Resonatorgrabenätzung kann damit entfallen. Die Trennflächen 15 können entweder durch Ätzen oder Ritzen und Brechen erzeugt werden. Anschließend werden sie zur Herstellung von Resonatorspiegeln beschichtet. Als weiterer Vorteil ergibt sich, dass der galvanische Abscheideprozess bei Raumtemperatur statt finden kann. Dies ermöglicht es galvanische Schichten wie zum Beispiel Silberschichten mit sehr hoher Wärmleitfähigkeit abzuscheiden, deren thermische Ausdehnungskoeffizienten nicht an das Substratmaterial - zum Beispiel GaAs - ängepasst sind. Würde statt dem galvanischen Abscheiden ein Lotverfahren zur Montage auf das Wärmeleitelement Verwendung finden, so könnte dies bei den üblichen Löttemperaturen von wenigsten 100 Grand Celsius zu erheblichen thermischen Verspannungen im - zum Beispiel gedünnten -, circa 7µm dicken Halbleiterlaser 21 mit Kantenmaßen von circa 1mm mal 1mm (Variationen von 0,05 bis 5mm sind möglich) führen.

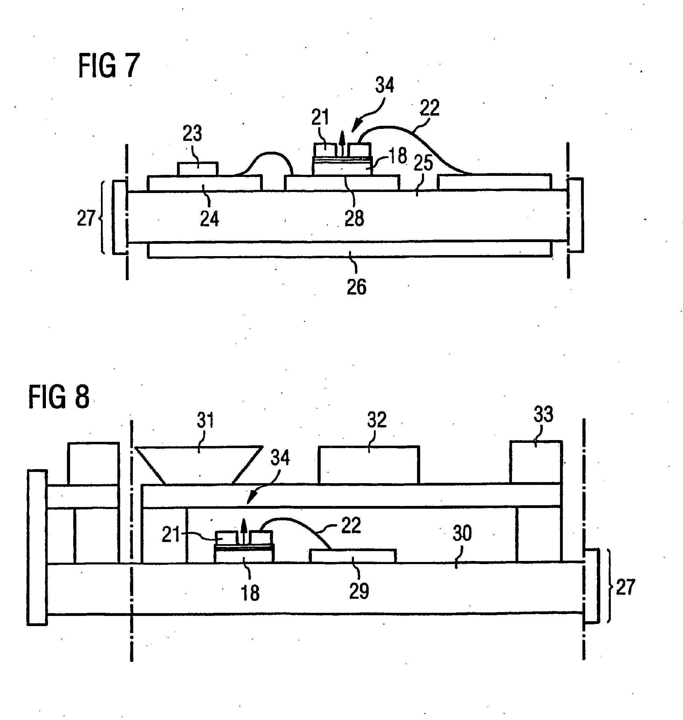

Figur 7 zeigt eine schematische Schnittdarstellung einer der oben beschriebenen oberflächenemittierenden Halbleiterlaservorrichtungen 34 mit dem Halbleiterlaser 21 und dem Wärmeleitelement 18, die auf einen Träger 27 montiert ist. Der Träger 27 ist beispielsweise ein Nutzen, d. h. ein planares Substrat mit zweidimensional wiederkehrenden Strukturen. Die oberflächenemittierende Halbleiterlaservorrichtung 34 wird beispielsweise mittels einer Verbindungstechnik wie Löten auf den Träger 27 montiert. Der Träger kann dabei weiter Komponenten wie beispielsweise optische Komponenten (31,32,33) oder Temperaturmesswiderstände 23 enthalten. Als Träger mit einem Metall- 24, Nichtmetall- 25, Metall- 26 Aufbau kommen beispielsweise folgende Strukturen in Frage: Direct Bonded Copper (DBC), Cu-AlN-Cu, Cu-Al₂O₃-Cu, Cu-Si-Cu. Zur elektrischen Kontaktierung kann die oberflächenemittierende Halbleiterlaservorrichtung 34 mittels Bonddrähten 22 mit dem Träger 27 verbunden sein.

Bevorzugt zeichnet sich der Träger dabei durch eine besonders gute Wärmeleitfähigkeit aus, sodass die Wärme vom Wärmeleitelement 18 über die Montagefläche 28 besonders gut vom Träger 27 aufgenommen werden kann.

Figur 8 zeigt die Montage der oberflächenemittierenden Halbleiterlaservorrichtung auf einem Träger 27, der keinen Sandwichaufbau aufweist. Beispielsweise kann der Träger eines oder mehrere der folgenden Materialien enthalten: Al, Cu, CuW, Ag, SiC, Al₂O₃, AlN, BN, SiC.

Wenn der Träger 27 dabei nicht oder schlecht elektrisch leitende Materialien enthält, kann der Träger 27 beispielsweise eine Dünnfilm- oder eine Dickschichtmetallisierung 30 aufweisen. Auf einen metallischen Träger 27 kann beispielsweise eine Leiterplatte 29 oder eine leiterplattenähnliche Anordnung 29 aufgebracht sein. Die dargestellte Anordnung weist zudem noch einen optischen Prismenaufbau (OPA, Optical Prism Assembly) auf. Der Aufbau kann beispielsweise ein Prisma oder einen Strahlteiler 31, ein nicht-lineares Material zur Frequenzkonversion 32 und einen Resonatorspiegel 33 enthalten.

## Patentansprüche

1. Oberflächenemittierende Halbleiterlaservorrichtung, aufweisend
- wenigstens einen oberflächenemittierenden Halbleiterlaser (21) mit einem Vertikalemitter (1) und wenigstens einer Pumpstrahlquelle (2), die nebeneinander monolithisch auf ein gemeinsames Substrat (13) integriert sind und
- ein Wärmeleitelement (18), das sich in thermischem Kontakt mit dem Halbleiterlaser (21) befindet und eine Montagefläche (28) aufweist, die zur Montage auf einem Träger (27) vorgesehen ist,
**dadurch gekennzeichnet, dass**
das Substrat (13) auf der dem Halbleiterlaser gegenüberliegenden Seite wenigstens eine Ausnehmung aufweist, die das Wärmeleitelement (18) enthält.

2. Halbleiterlaservorrichtung nach Anspruch 1,
bei der das Wärmeleitelement (18) elektrisch leitfähig ist.

3. Halbleiterlaservorrichtung nach Anspruch 1 oder 2,
bei der das Wärmeleitelement (18) geeignet ist, den Halbleiterlaser (21) elektrisch zu kontaktieren.

4. Halbleiterlaservorrichtung nach einem der Ansprüche 1 bis 3,
bei der das Wärmeleitelement (18) wenigstens eines der folgenden Materialien enthält: Kupfer, Diamant, Silber, Al₂O₃, AlN, SiC, BN, Kupfer-Diamant.

5. Halbleiterlaservorrichtung nach einem der Ansprüche 1 bis 4,
bei der zwischen Wärmeleitelement (18) und Halbleiterlaser (21) eine thermisch beständige Haftung besteht.

6. Halbleiterlaservorrichtung nach Anspruch 1,
bei der die Ausnehmung in das Substrat (13) geätzt ist.

7. Halbleiterlaservorrichtung nach einem der Ansprüche 1 oder 6,
bei der das Wärmeleitelement (13) galvanisch in die Ausnehmung abgeschieden ist.

8. Halbleiterlaservorrichtung nach einem der vorangegangenen Ansprüche,
bei der die Pumpstrahlquelle (2) wenigstens eine geätzte Resonatorfacette (15) aufweist.

9. Verfahren zur Herstellung einer oberflächenemittierenden Halbleiterlaservorrichtung mit den folgenden Schritten:
- Bereitstellen einer Vielzahl von oberflächenemittierenden Halbleiterlasern (21), die jeweils einen Vertikalemitter (1) und wenigstens eine Pumpstrahlquelle (2) aufweisen, die monolithisch nebeneinander auf ein gemeinsames Substrat (13) integriert sind;
- Herstellen wenigstens einer Ausnehmung pro Halbleiterlaser (21) auf der dem Halbleiterlaser gegenüberliegenden Seite des Substrats (13) mittels eines Ätzprozesses;
- galvanisches Abscheiden von wärmeleitendem Material (18) in die Ausnehmungen,
- Vereinzeln der Anordnung.

## Claims

1. Surface emitting semiconductor laser device, comprising
- at least one surface emitting semiconductor laser (21) having a vertical emitter (1) and at least one pump radiation source (2), which are monolithically integrated alongside one another onto a common substrate (13), and
- a heat-conducting element (18), which is in thermal contact with the semiconductor laser (21) and has a mounting area (28) provided for mounting on a carrier (27),
**characterized in that**
the substrate (13) has at least one cutout which contains the heat-conducting element (18) on the opposite side to the semiconductor laser.

2. Semiconductor laser device according to Claim 1,
in which the heat-conducting element (18) is electrically conductive.

3. Semiconductor laser device according to Claim 1 or 2,
in which the heat-conducting element (18) is suitable for making electrical contact with the semiconductor laser (21).

4. Semiconductor laser device according to one of Claims 1 to 3,
in which the heat-conducting element (18) contains at least one of the following materials: copper, diamond, silver, Al₂O₃, AlN, SiC, BN, copper-diamond.

5. Semiconductor laser device according to one of Claims 1 to 4,
in which there is a thermally stable adhesion between heat-conducting element (18) and semiconductor laser (21).

6. Semiconductor laser device according to Claim 1,
in which the cutout is etched into the substrate (13).

7. Semiconductor laser device according to either of Claims 1 and 6,
in which the heat-conducting element (13) is electrodeposited into the cutout.

8. Semiconductor laser device according to one of the preceding claims,
in which the pump radiation source (2) has at least one etched resonator facet (15).

9. Method for producing a surface emitting semiconductor laser device comprising the following steps:
- provision of a multiplicity of surface emitting semiconductor lasers (21) which in each case have a vertical emitter (1) and at least one pump radiation source (2), which are monolithically integrated alongside one another onto a common substrate (13);
- production of at least one cutout per semiconductor laser (21) on the opposite side of the substrate (13) to the semiconductor laser by means of an etching process;
- electrodeposition of heat-conducting material (18) into the cutouts,
- singulation of the arrangement.

## Revendications

1. Dispositif laser à semi-conducteur à émission par la surface comprenant,
- au moins un laser (21) à semi-conducteur à émission par la surface, ayant un émetteur (1) vertical et au moins une source (2) de rayonnement de pompage, qui sont intégrés les uns à côté des autres monolithiquement sur un substrat (13) commun et,
- un élément (18) conducteur de la chaleur, qui se trouve en contact thermique avec le laser (21) à semi-conducteur et qui a une surface (28) de montage, qui est prévue pour le montage sur un support (27),
**caractérisé en ce que**,
le substrat (13) a, du côté opposé au laser à semi-conducteur, au moins un évidement qui contient l'élément (18) conducteur de la chaleur.

2. Dispositif laser à semi-conducteur suivant la revendication 1,
dans lequel l'élément (18) conducteur de la chaleur est conducteur de l'électricité.

3. Dispositif laser à semi-conducteur suivant la revendication 1 ou 2,
dans lequel l'élément (18) conducteur de la chaleur est propre à être mis en contact électriquement avec le laser (21) à semi-conducteur.

4. Dispositif laser à semi-conducteur suivant l'une des revendications 1 à 3,
dans lequel l'élément (18) conducteur de la chaleur contient au moins l'un des matériau suivants : cuivre, diamant, argent, Al₂O₃, AlN, SiC, BN, cuivre-diamant.

5. Dispositif laser à semi-conducteur suivant l'une des revendications 1 à 4,
dans lequel il y a une adhérence qui résiste thermiquement entre l'élément (18) conducteur de la chaleur et le laser (21) à semi-conducteur.

6. Dispositif laser à semi-conducteur suivant la revendication 1,
dans lequel l'évidement dans le substrat (3) est ménagé par gravure.

7. Dispositif laser à semi-conducteur suivant l'une des revendications 1 ou 6,
dans lequel l'élément (13) conducteur de la chaleur est déposé galvaniquement dans l'évidement.

8. Dispositif laser à semi-conducteur suivant l'une des revendications précédentes,
dans lequel la source (2) de rayonnement de pompage a au moins une facette (15) de résonateur ménagée par gravure.

9. Procédé de production d'un dispositif laser à semi-conducteur à émission par la surface, ayant les stades suivants :
- on se procure une pluralité de lasers (21) à semi-conducteur à émission par la surface, qui ont respectivement un émetteur (1) vertical et au moins une source de rayonnement de pompage, qui sont intégrés monolithiquement les uns à côté des autres sur un substrat (13) commun ;
- on ménage au moins un évidement par laser (21) à semi-conducteur du côté du substrat (13) opposé au laser à semi-conducteur au moyen d'un processus de gravure ;
- on dépose galvaniquement du matériau (18) conducteur de la chaleur dans les évidements ;
- on individualise l'arrangement.
